# EUROPEAN PATENT SPECIFICATION

(11) **EP 2 980 993 B1**
(45) Date of publication and mention of the grant of the patent: **23.10.2019**
(21) Application number: 14179081.6
(22) Date of filing: 30.07.2014
(51) Int. Cl.: H02M 3/335, H03K 17/0412, H02M 1/00, H05B 33/08

(54) **Operating device for a light source and method of controlling an operating device**
Betriebsgerät für eine Lichtquelle und Verfahren zum Steuern eines Betriebsgeräts
Dispositif de fonctionnement pour une source de lumière et procédé de commande d'un tel dispositif

(43) Date of publication of application: 03.02.2016
(73) Proprietor: Tridonic GmbH & Co KG, 6851 Dornbirn (AT)
(72) Inventor: Kelly, Jamie, North Shields Tyne and Wear NE29 8AH (GB)
(74) Representative: Banzer, Hans-Jörg

(56) References cited:
- US-A- 4 873 460
- US-A1- 2011 140 619
- US-A1- 2011 221 480
- US-A1- 2013 049 816

## Description

### TECHNICAL FIELD

Embodiments of the invention relate to operating devices for lights sources and to methods of operating controlling operating devices. Embodiments of the invention relate in particular to an operating device for a light source which comprises a controllable switch.

### BACKGROUND

Novel light sources such as light sources based on light emitting diodes (LEDs) or discharge lamps become increasingly more popular. Operating devices for such light sources are operative to provide an output current or output voltage to a light-emitting means of the light source. The operating devices may also be configured to perform additional functions, including control and/or communication functions.

In this context, US 2011/0140619 A1 discloses a differential driving circuit for powering a light source. The differential driving circuit includes a first set of switches and a second set of switches. A first current from power source flows through the first set of switches to charge of first energy storage element when the first set of switches is turned on. A second current from the first energy storage element flows through the second set of switches to power the light source when the second set of switches is turned on.

US 2011/0221480 A1 discloses an operating device according to the preamble of claim 1, which comprises a drive circuit, in particular a resonant gate drive circuit for a voltage controlled transistor. A resonant inductor and a resistor are connected to a gate of the voltage controlled transistor in series. The drive circuit is provided with two complementary switching elements connected in series.

US 2013/0049816 A1 relates to a power saving resonant gate driver, which comprises a resonant path configured to couple a gate of a power transistor to a supply capacitor, and a low impedance path configured to couple the gate of the power transistor to a voltage rail. The resonant gate driver selectively utilizes the resonant path during charging and discharging of the gate, and selectively utilizes the low impedance path to couple the gate to the voltage rail when the gate is neither charging nor discharging.

US 4,873,460 discloses a monolithic transistor gate energy recovery system. Transistors Q1 and Q2 are employed to switch a gate of a transistor/switching device. A capacitance of the transistor/switching device is alternately charged from a source through an inductance and discharged to the source of reference potential through the inductance as the transistors Q1 and Q2 are alternately switched.

An operating device for a light source frequently comprises a controllable switch. The controllable switch may be a transistor having an isolated gate electrode, e.g. a field effect transistor such as a metal-oxide-semiconductor field-effect transistor (MOSFET). Operating devices in which the controllable switch is switched at a high frequency are attractive for various reasons. One example where high switching frequencies may be beneficial includes the adjustment of output current.

Power dissipation increases with switching frequency. While various techniques may be used to address local heating problems, e.g. the provision of heat sinks, such techniques may make it difficult to provide the operating device with a compact construction. For illustration, it may be attractive to provide operating devices with a rather flat design in which a height, measured perpendicularly to a circuit board of the operating device, is small. For such flat designs of operating devices, high switching frequencies of controllable switches tend to create heating problems.

### SUMMARY

There is a continued need in the art for devices, systems and methods in which heating problems associated with switching of a controllable switch of an operating device for a light source are mitigated. There is in particular a need for devices, systems and methods which allow power dissipation associated with switching of a field effect transistor or other controllable switch to be reduced.

According to embodiments, resonance is used to reduce power losses. The resonance allows at least part of the energy to be recovered which would otherwise be dissipated. A gate driver circuit may be provided which comprises an inductance. The inductance is coupled to a gate of the controllable switch to form a resonance circuit. By using resonance for charging and/or discharging the gate of the controllable switch, dissipation may be reduced.

According to embodiments, an operating device, a system and a method as defined by the independent claims are provided. The dependent claims define features of further embodiments.

According to an embodiment, an operating device for a light source is provided. The operating device comprises a controllable switch which has a gate. The operating device comprises a gate driver circuit coupled to the gate of the controllable switch. The gate driver circuit comprises an inductance which forms a resonance circuit with a capacitance of the gate of the controllable switch.

The resonance circuit may be a series resonance circuit formed by the inductance and the gate.

The inductance may be a parasitic inductance or may comprise an inductive circuit element, e.g. a coil.

The resonance circuit may be configured to boost a gate voltage at the gate of the controllable switch. The driver circuit may then be supplied with a rail voltage, measured relative to a reference potential, which is less than the gate voltage applied at the gate by the gate driver circuit.

Alternatively or additionally, the resonance circuit may be configured to boost a current amplitude of a current flowing to the gate of the controllable switch and/or a current amplitude of a current flowing from the gate of the controllable switch.

The gate driver circuit comprises a first switch coupled in series with the inductance to a voltage rail, measured relative to a reference potential. The first switch may be electrically controllable. The first switch may be a first field effect transistor. The first switch may be a first MOSFET of the gate driver circuit.

The gate driver circuit may be configured to control a switching of the first switch in dependence on a resonance frequency of the resonance circuit. The gate driver circuit may be configured to control a switching into the conducting state and/or a switching into a low conductance state, i.e. an off state, of the first switch so as to allow a resonance current to flow through the first switch and the inductance to the gate.

The first switch and the inductance may be coupled in series between a voltage rail and the gate of the controllable switch. A voltage at the voltage rail, measured relative to a reference potential, may be equal to or less than a voltage at the gate when the controllable switch is switched into the conducting state.

The first switch and the inductance may be coupled in series such that a charging current for charging the gate flows through the first switch and the inductance. Soft-switching may be performed when switching the controllable switch to the conducting state.

The gate driver circuit comprises a second switch coupled via the inductance to the gate of the controllable switch. The second switch is connected in between the inductance and the reference potential. The second switch may be electrically controllable. The second switch may be a second field effect transistor. The second switch may be a second MOSFET of the gate driver circuit.

The second switch may be connected to the gate in such a manner that the gate is discharged through the inductance and the second switch when the second switch is in a conducting state. Soft-switching may thereby be performed also when switching off the controllable switch.

The second switch may be connected to the gate in such a manner that a discharge current from the gate flows through the second switch when the second switch is in a conducting state. Hard-switching may be performed also when switching off the controllable switch.

The gate driver circuit may be configured to switch the second switch to a conducting state to switch the controllable switch to the low conductance state, i.e. to the off state.

The gate driver circuit is configured to control a switching of both the first switch and the second switch in dependence on a resonance frequency of the resonance circuit.

The first switch and the second switch may be integrated in one integrated circuit. The inductance may be connected, directly or via a diode, to a first terminal of the integrated circuit. The first terminal may be connected to an electrode of the first switch.

The gate driver circuit comprises a third switch coupled to the gate of the controllable switch. The third switch is connected in between the gate of the controllable switch and the reference potential. The gate driver circuit is configured to control the second switch and the third switch such that the second switch and the third switch are switched to a conducting state in a time-offset manner. The gate driver circuit may be configured to control the second switch and the third switch such that at most one of the second switch and the third switch is switched to the conducting state at any time to discharge the gate.

The gate driver circuit may be configured to perform a soft-switching when switching on and/or when switching off the controllable switch.

The controllable switch may be a controllable switch of a transformer having a potential barrier. The controllable switch may be a controllable switch of a half-bridge of the transformer. The transformer may be a LLC resonant converter.

The operating device may be a LED converter.

The LED converter may have a housing. The housing may have opposite major faces. A distance between the opposite major faces may be less than 1 cm.

A light source according to an embodiment comprises a light-emitting means comprising at least one light emitting diode (LED). The light source comprises the operating device according to any one of the embodiments. An output of the operating device is connected to the light-emitting means to supply an operating current to the light-emitting means.

The at least one LED may comprise an inorganic LED and/or an organic LED.

A method of controlling an operating device for a light source according to an embodiment is provided. The operating device comprises a controllable switch having a gate. The method comprises controlling the controllable switch by a gate driver circuit coupled to the gate of the controllable switch, wherein the gate driver circuit comprises an inductance which forms a resonance circuit with a capacitance of the gate of the controllable switch. The gate driver circuit comprises a first switch coupled in series with the inductance to a voltage rail, measured relative to a reference potential. The gate driver circuit comprises a second switch coupled via the inductance to the gate of the controllable switch and connected in between the inductance and the reference potential. The gate driver circuit comprises a third switch coupled to the gate of the controllable switch and connected in between the gate of the controllable switch and the reference potential. The gate driver circuit is configured to control the second switch and the third switch such that the second switch and the third switch are switched to a conducting state in a time-offset manner.

The method may be performed by the operating device according to any one of the embodiments.

In any one of the various embodiments, the controllable switch may be a controllable power switch. The controllable switch may be a semiconductor switch having an isolated gate electrode. The controllable switch may be a field effect transistor (FET). The controllable switch may be a metal oxide semiconductor field effect transistor (MOSFET).

In devices, methods and systems according to embodiments, a gate driver circuit comprising an inductance which resonates with a capacitance of the gate is used. This allows power dissipation to be reduced.

### BRIEF DESCRIPTION OF THE SEVERAL VIEWS OF THE DRAWINGS

Embodiments of the invention will be described in detail with reference to the drawings in which like reference numerals designate like elements.
FIG. 1 is a diagram of a light source comprising an operating device according to an embodiment.
FIG. 2 is a circuit diagram of an operating device according to an embodiment.
FIG. 3 illustrates a time-dependent control of switches of a gate driver circuit of FIG. 2 according to an embodiment.
FIG. 4 is a circuit diagram of an operating device according to an embodiment.
FIG. 5 is a circuit diagram of an operating device according to an embodiment.
FIG. 6 is a circuit diagram of an operating device according to an embodiment.

### DETAILED DESCRIPTION OF EMBODIMENTS

Exemplary embodiments of the invention will now be described in detail with reference to the drawings.

According to embodiments of the invention, resonance is used to mitigate dissipation problems for an operating device for a light source. The operating device may comprise a controllable switch which may be a field effect transistor (FET), e.g. a metal-oxide-semiconductor field-effect transistor (MOSFET). A gate driver circuit comprises an inductance which forms a resonance circuit with a capacitance of a gate of the controllable switch. The gate driver circuit may comprise at least one switch which is switched on and off in a manner coordinated with a current which flows through the inductance to and/or from the gate of the controllable switch.

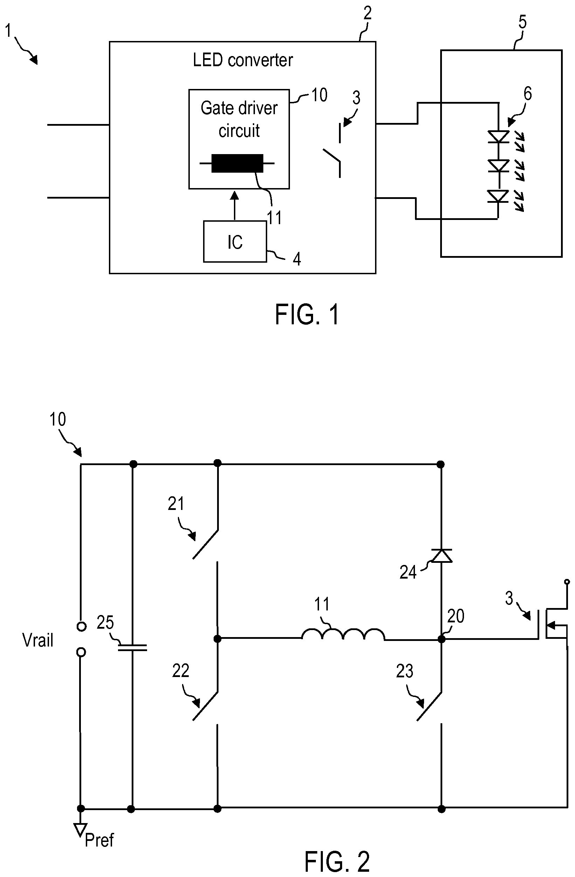

FIG. 1 is a diagram of a light source 1 according to an embodiment. The light source 1 comprises an operating device 2 which may be configured as a LED converter. The light source 1 comprises a light emitting means 5. An output current of the operating device 2 is fed to the light emitting means 5. The light emitting means 5 may comprise one light emitting diode (LED) or plural LEDs 6. The one or plural LED(s) 6 may be inorganic and/or organic LEDs. The operating device 2 may operate as a current source for the LED(s) 6.

The operating device 2 may comprise a transformer. A controllable switch 3 of the transformer may be switched on and off to provide the output current to the light emitting means 5. The controllable switch 3 has a gate. The controllable switch 3 may be a semiconductor switch having an isolated gate. The controllable switch 3 may be a FET. The controllable switch 3 may be a MOSFET. The controllable switch 3 may be a power switch of a DC/DC converter, for example. The controllable switch 3 may be connected between the input of the driver circuit 21 and a transformer inductance.

Switching of the controllable switch 3 may be controlled by an integrated circuit 4. The integrated circuit 4 may perform an open loop or closed loop control to control switching of the controllable switch 3. The integrated circuit 4 may comprise one or several of an application specific integrated circuit (ASIC), a controller, a microcontroller, a processor, a microprocessor or a combination of such components.

The operating device 2 comprises a gate driver circuit 10. The gate driver circuit 10 is coupled to the gate of the controllable switch 3. The gate driver circuit 10 may be configured to perform a soft-switching for at least one of switching the controllable switch 3 to the conducting state, i.e. on-state, or switching the controllable switch 3 to the low conductance state, i.e. off-state.

The gate driver circuit 10 comprises an inductance 11 which is electrically connected to the gate of the controllable switch 3. The inductance 11 and the capacitance of the gate of the controllable switch 3 may form a resonance circuit. The resonance may be used for boosting a current and/or potential change when charging the gate of the controllable switch 3 and/or when discharging the gate of the controllable switch 3.

The gate driver circuit 10 may comprise at least one switch which is switched on or off to charge or discharge the gate of the controllable switch. At least for one of charging or discharging the gate of the controllable switch 3, current may flow between the at least one switch and the gate of the controllable switch 3 through the inductance 11. Soft-switching may thereby be attained. A switching of the at least one switch of the gate driver circuit 10 may be set in accordance with a resonance frequency of the resonance circuit formed by the inductance 11 and the capacitance of the gate of the controllable switch 3.

In any one of the various embodiments, the inductance 11 may be or may comprise an inductive element. The inductance 11 may comprise a coil, for example. The inductance 11 may also consist of or may comprise a parasitic inductance.

FIG. 2 is a circuit diagram of a gate driver circuit 10 of an operating device according to an embodiment. An output node of the gate driver circuit 10 is connected to the gate of the controllable switch 3.

The gate driver circuit 10 receives a rail voltage Vrail as input voltage. The rail voltage Vrail may be set to be equal or less than the voltage which is applied to the gate of the controllable switch 3 to switch the controllable switch 3 to the conducting state.

The gate driver circuit 10 comprises an inductance 11, a first switch 21, and a second switch 22. The gate driver circuit 10 may also comprise a third switch 23. It is to be understood that the first switch 21, the second switch 22 and, if present, the third switch 23 may respectively be electrically controllable. In order to avoid confusion with the controllable switch 3, the first switch 21, the second switch 22 and, if present, the third switch 23 will simply be referred to as "switch".

Each one of the first switch 21, the second switch 22 and, if present, the third switch 23 of the gate driver circuit 10 may respectively be a semiconductor switch. Each one of the first switch 21, the second switch 22 and, if present, the third switch 23 of the gate driver circuit 10 may respectively be a FET. Each one of the first switch 21, the second switch 22 and, if present, the third switch 23 of the gate driver circuit 10 may respectively be a MOSFET. The third switch 23 may have a source-drain resistance when switched to the on-state which is larger than a source-drain resistance of the second switch 22 when switched to the on-state.

The gate driver circuit 10 is configured such that the gate of the controllable switch 3 may be charged through the first switch 21 and the inductance 11. The first switch 21 is switched to the on-state for this purpose. The first switch 21 is connected in between a voltage rail at which the voltage Vrail is provided and the inductance 11.

The gate driver circuit 10 is configured such that the gate of the controllable switch 3 may be discharged through the second switch 22 and the inductance 11. The second switch 22 is switched to the on-state for this purpose. The second switch 22 is connected in between the inductance 11 and a reference potential Pref, which may be a mass potential.

The gate driver circuit 10 is configured such that the third switch 23 is connected in between the gate of the controllable switch 3 and the reference potential Pref. The third switch 23 may have a clamp diode which is connected across it. The clamp diode may be provided by the source-drain path of the semiconductor switch which forms the third switch 23. The third switch may allow the gate of the controllable switch 3 to be discharged to zero voltage after the discharge current has flown through the inductance 11 and the second switch 22.

The first switch 21 and the second switch 22 may be switched on and off under the control of the integrated circuit 4. The first switch 21 and the second switch 22 may respectively be switched on and off in such a way that at most one of the first switch 21 and the second switch 22 is in an on-state at any time during operation. A timing at which the first switch 21 and the second switch 22 are switched on and off, respectively, may be matched to resonance frequency of the resonance circuit formed by the inductance 11 and the capacity of the gate of the controllable switch 23. Resonant enhancement of charging and/or discharging currents may be obtained thereby, and at least part of the energy which would normally be dissipated can be recovered by the resonance.

The third switch 23 may also be switched on and off under the control of the integrated circuit 4. The first switch 21, the second switch 22 and the third switch 23 may respectively be switched on and off in such a way that at most one of the first switch 21, the second switch 22 and the third switch 23 is in an on-state at any time during operation.

The first switch 21, the second switch 22 and the third switch 23 may be switched to the on and off states in a cyclic manner to complete a cycle of switching on and off the controllable switch 3. Each of the first switch 21, the second switch 22 and the third switch 23 may be switched to the on-state once per cycle. The switching may be implemented such that, in each cycle, the first switch 21 is switched on to charge the gate of the controllable switch 3 and is switched off to terminate the charging. Then, the second switch 22 may be switched on when the controllable switch 3 is to be set to the off-state again. The second switch 22 may be switched off to terminate the discharging of the gate of the controllable switch 22. Then, the third switch 23 may be switched on to allow remaining charge on the gate of the controllable switch 3 to be discharged. The third switch 23 may be switched off before the next cycle starts by switching the first switch 21 on.

The first switch 21 and the second switch 22 may each be a MOSFET. The first switch 21 and the second switch 22 may each be a MOSFET having a low resistance when in the on-state with a reverse clamping diode. The third switch 23 may have a resistance which is greater than that of the second switch 22 when in the on-state.

The gate driver circuit 10 may further comprise a diode 24 connected in between the gate of the controllable switch 3 and the rail at which the rail voltage Vrail is provided. The diode 24 prevents the voltage at the gate of the controllable switch 3 from exceeding the rail voltage Vrail. The diode 24 may have any one of a variety of implementations. For illustration, the diode 24 may be a diode-connected transistor.

The gate driver circuit 10 may comprise additional components. For illustration, an input capacity 25 may be provided to perform low-pass filtering. The input capacity 25 may also be omitted.

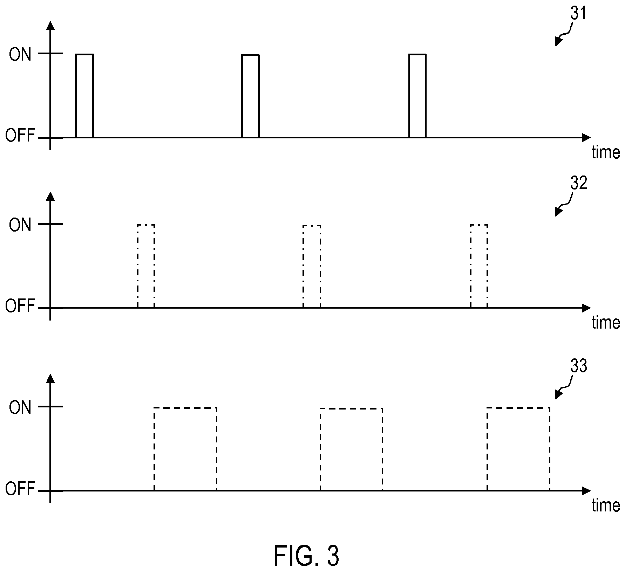

FIG. 3 is a diagram which illustrates operation of the gate driver circuit 10. Resonant recovery of energy which reduces switching losses may be attained by switching the first switch 21, the second switch 22 and, if present, the third switch 23 in a coordinated manner. FIG. 3 shows a state 31 of the first switch 21, a state 32 of the second switch 22, and a state 33 of the third switch 23 as a function of time.

In order to execute one switching cycle of the controllable switch 3 in which the controllable switch 3 is switch on and off, the first switch 21 is first set to the on-state as shown at 31. The second switch 22 and the third switch 23 are in the off state at this time. A charging current flows through the first switch 21 and the inductance 11. Soft-switching may be implemented thereby. The first switch 21 may be set to the off state once the gate of the controllable switch 3 has been charged to set the controllable switch 3 to the on state.

After a time delay, which may be determined by a desired output current, for example, the second switch 22 is set to the on state as shown at 32. The first switch 21 and the third switch 23 are in the off state at this time. A discharge current flows through the inductance 11 and the second switch 22. Soft-switching may be implemented thereby. The second switch 22 may be set to the off state once the gate of the controllable switch 3 has been discharged to set the controllable switch 3 to the off state.

When the second switch 22 has been set to the off state, the third switch 23 may be switched on as shown at 33. Thereby, energy which is still left in the resonance circuit formed by the inductance 11 and the capacitance of the gate of the controllable switch 3 may be dissipated. This energy will typically be much less than the energy discharged from the resonance circuit through the inductance 11 and the second switch 22. The first switch 21 and the second switch 22 are in the off-state while the third switch 23 is in the on-state. The third switch 23 may be set to the off-state before the next cycle starts by switching the first switch to the on state, as shown at 31.

As shown in FIG. 3, the switches of the gate driver circuit 10 may be controlled in a cyclic manner to switch the controllable switch 3 to the on and off states in a cyclic manner.

The controllable switch 3 driven by the gate driver circuit 10 may be arranged such that it soft commutates to zero volts before the gate driver circuit 10 switches it on.

The resonant circuit may be used for switching the controllable switch 3 both on and off. In other implementations, the resonant circuit may be used for switching the controllable switch 3 on, but not for switching it off, as will be explained in more detail below. In still other implementations, the resonant circuit may be used for switching the controllable switch 3 off, but not for switching it on. Switching off may be performed as hard switching, forcing the gate voltage to zero volts, as will be explained in more detail below.

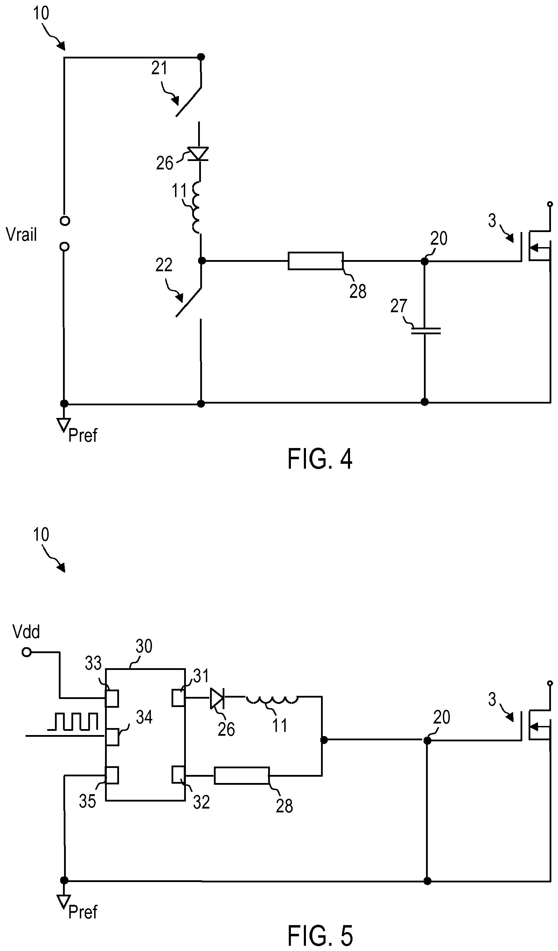

FIG. 4 is a circuit diagram of a gate driver circuit 10 of an operating device according to an embodiment. The gate driver circuit 10 is operative to charge the gate of the controllable switch 3 with a resonant pulse of current. A voltage boost may be attained, i.e., the rail voltage Vrail may be set to be less than the gate voltage established at the gate by the gate driver circuit 10 for switching the controllable switch 3 on.

The gate driver circuit 10 comprises a first switch 21 and a second switch 22. The first switch 21 and the second switch 22 may respectively be configured as explained with reference to FIG. 2. The first switch 21 and the second switch 22 may respectively be electrically controllable semiconductor switches, e.g. MOSFETs.

The gate driver circuit 10 comprises an inductance 11. The inductance 11 is connected in between the first switch 21 and the gate of the controllable switch 3. A blocking diode 26 may be connected between the first switch and the inductance 11. A resistance 28 may be connected between the inductance and the gate of the controllable switch 3 for implementing a soft switching through the inductance 11.

The second switch 22 may be connected to the gate of the controllable switch 3. The second switch 22 may be connected such that the gate of the controllable switch 3 may be discharged through the second switch 22. The discharge current does not need to flow through the inductance 11. An output capacitance 27 may optionally be connected between the gate of the controllable switch 3 and the reference potential Pref.

In operation, the first switch 21 and the second switch 22 may be controlled by the integrated circuit 4. The first switch 21 and the second switch 22 may be switched on and off in a coordinated manner. A switching similar to that shown at 31 and 32 in FIG. 3 may be implemented. The first switch 21 may respectively be switched on to charge the gate of the controllable switch 3. The second switch 22 may respectively be switched off to discharge the gate of the controllable switch 3. A dead time may be added between the switching off of the first switch 21 and the switching on of the second switch 22 to mitigate a risk of shoot through. A dead time may be added between the switching off of the second switch 22 and the switching on of the first switch 21 to mitigate a risk of shoot through.

When the first switch 21 is switched on, the controllable switch 3 is switched on by soft-switching. A resonant pulse of current through the first switch 21 and the inductance 11 charges the gate of the controllable switch 3. The first switch 21 thereby switched the gate high via the blocking diode 26 and the inductance 11.

Switching off may be performed as hard switching. The second switch 22 is switched on when a dead time after switching off of the first switch 21 expired. The second switch 22 may discharge the gate, without requiring the current to flow through the inductance. A third switch 23 as explained with reference to FIG. 2 may be provided, but may also be omitted, because the hard switching forces the gate voltage to zero volts.

In an operating device having a gate driver circuit 10 as explained with reference to FIG. 4, the gate driver circuit 10 may be operated with a voltage Vrail which is less than the voltage at the gate of the controllable switch 3 when the controllable switch is in the on-state. The gate driver circuit 10 boosts the gate voltage. Power dissipation may be reduced compared to a control in which hard switching is performed both for switching the controllable switch 3 and for switching the controllable switch 3 off.

Some or all of the components of the gate driver circuit 3 may be integrated into an integrated circuit. For illustration, the first and second switches 21, 22 may be integrated into an integrated circuit which may be identical to the integrated circuit 4 or which may be separate from the integrated circuit.

FIG. 5 is a circuit diagram of a gate driver circuit 10 of an operating device according to an embodiment. The gate driver circuit 10 is operative to charge the gate of the controllable switch 3 with a resonant pulse of current.

An integrated circuit 30 comprises a first switch coupled to a first output 31 and a second switch coupled to a second output 32 of the integrated circuit. A diode 26 and inductance 11 are connected between the first terminal 31 and the gate of the controllable switch 3. A resistance 28 may be connected between the second terminal 32 and the gate of the controllable switch 3.

The first switch and the second switch of the integrated circuit 30 may be switched on and off as explained with reference to FIG. 4. The first switch of the integrated circuit 30 may be switched on such that a resonant pulse of current charges the gate of the controllable switch 3 via the diode 26 and the impedance 11. The second switch of the integrated circuit 30 may be switched on to discharge the gate, thereby setting the controllable switch 3 to the off-state.

The integrated circuit 30 may have various other terminals, including supply terminals 33, 35 and, optionally, a terminal 34 for receiving a clock or control signal.

The gate driver circuits according to embodiments may be used in a wide variety of different converters. For illustration, the gate driver circuit according to an embodiment may be coupled to a gate of a controllable switch of a buck converter, a boost converter, a buck-boost converter, a flyback converter, or a resonance converter. For a converter having a half bridge comprising a first controllable switch and a second controllable switch, a gate driver circuit according to an embodiment may be provided for at least one or for each one of the first and second controllable switches.

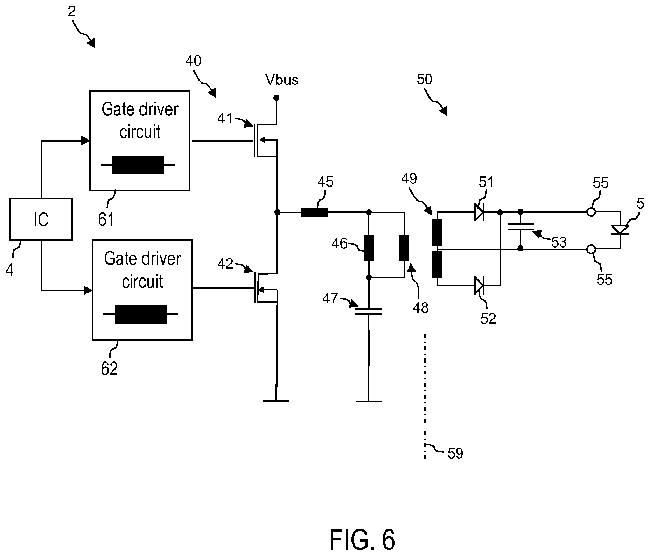

FIG. 6 is a circuit diagram of an operating device 2 according to an embodiment. The operating device 2 comprises an LLC resonance converter. A transformer may be formed by impedances 48, 49 to provide a galvanic isolation. A potential barrier 59 may be formed between a primary side 40 and a secondary side 50.

A LLC resonance circuit may be formed by an inductance 45 of the LLC resonance circuit, a further inductance 46 of the LLC resonance circuit which may be a stray inductance of the transformer inductance 48, and a capacitance 47 which may be formed by a capacitor or a parasitic capacitance. The inductances 45, 46 of the LLC resonance circuit must not be confused with the inductances of the gate driver circuit 61, 62 which resonate with the gates of controllable switches.

The secondary side 50 may comprise diodes 51, 52 for rectification, an output capacitor 53 and output terminals 55.

The LLC resonant converter may have a half bridge configuration comprising a first controllable switch 41 and a second controllable switch 42. A first gate driver circuit 61 according to an embodiment may be coupled to a gate of the first controllable switch 41. A second gate driver circuit 62 according to an embodiment may be coupled to a gate of the second controllable switch 42. In other implementation, a gate driver circuit according to an embodiment may be used for only one of the first and the second controllable switches 41, 42, while the other one of the first and the second controllable switches 41, 42 is controlled by hard-switching.

The operating devices according to embodiments allow power dissipation problems to be mitigated by using resonant current pulses for charging and/or discharging the gate of the controllable switch. This allows higher switching frequencies to be used for a given construction space and cooling configuration of an operating device. Alternatively or additionally, the sizes of heat sinks may be reduced while maintaining the same maximum switching frequency.

While embodiments have been described in detail with reference to the drawings, modifications may be implemented in other embodiments. For illustration rather than limitation, while embodiments have been described in which the gate of the controllable switch is charged to switch the controllable switch into the conducting state, the gate may also be discharged to switch the controllable switch into the conducting state. The controllable switch may accordingly be implemented as either one of a p-channel or n-channel MOSFET, for example.

Embodiments of the invention may be used in lighting systems. Embodiments of the invention may in particular be used for operating devices which feed current to LEDs, without being limited thereto.

## Claims

1. An operating device for a light source (1), comprising:
a controllable switch (3) which has a gate; and
a gate driver circuit (10) coupled to the gate of the controllable switch (3),
wherein the gate driver circuit (10) comprises an inductance (11) forming a resonance circuit with a capacitance of the gate of the controllable switch (3),
wherein the gate driver circuit (10) comprises a first switch (21) coupled in series with the inductance (11) to a voltage rail, measured relative to a reference potential,
wherein the gate driver circuit (10) comprises a second switch (22) coupled via the inductance (11) to the gate of the controllable switch (3) and connected in between the inductance (11) and the reference potential,
**characterized in that** the gate driver circuit (10) comprises a third switch (23) coupled to the gate of the controllable switch (3) and connected in between the gate of the controllable switch (3) and the reference potential,
wherein the gate driver circuit (10) is configured to control the second switch (22) and the third switch (23) such that the second switch (22) and the third switch (23) are switched to a conducting state in a time-offset manner.

2. The operating device of claim 1,
wherein the resonance circuit is configured to boost
a gate voltage at the gate of the controllable switch (3), and/or
a current amplitude of a current flowing to the gate of the controllable switch (3).

3. The operating device of claim 1 or claim 2,
wherein the gate driver circuit (10) is configured to control a switching of the first switch (21) in dependence on a resonance frequency of the resonance circuit.

4. The operating device of any one of the preceding claims,
wherein the first switch (21) and the inductance (11) are coupled in series between the voltage rail and the gate of the controllable switch (3).

5. The operating device of any one of the preceding claims,
wherein the gate driver circuit (10) is configured to control a switching of both the first switch (21) and the second switch (22) in dependence on a resonance frequency of the resonance circuit.

6. The operating device of any one of the preceding claims,
wherein the first switch (21) and the second switch (22) are included in one integrated circuit (30).

7. The operating device of any one of the preceding claims,
wherein the gate driver circuit (10) is configured to perform a soft-switching when switching on and/or when switching off the controllable switch (3).

8. The operating device of any one of the preceding claims,
wherein the controllable switch (3) is a controllable switch of a transformer (41, 42, 45-49) having a potential barrier (59).

9. The operating device of any one of the preceding claims,
wherein the operating device (10) is a LED converter.

10. A light source, comprising:
a light-emitting means (5) comprising at least one light emitting diode (6), and
the operating device (10) of any one of the preceding claims, wherein an output of the operating device (10) is connected to the light-emitting means (5) to supply an operating current to the light-emitting means (5).

11. A method of controlling an operating device for a light source (1), the operating device comprising a controllable switch (3) having a gate, the method comprising:
controlling the controllable switch (3) by a gate driver circuit (10) coupled to the gate of the controllable switch (3), wherein the gate driver circuit (10) comprises an inductance (11) which forms a resonance circuit with a capacitance of the gate of the controllable switch (3),
wherein the gate driver circuit (10) comprises a first switch (21) coupled in series with the inductance (11) to a voltage rail, measured relative to a reference potential,
wherein the gate driver circuit (10) comprises a second switch (22) coupled via the inductance (11) to the gate of the controllable switch (3) and connected in between the inductance (11) and the reference potential,
**characterized in that** the gate driver circuit (10) comprises a third switch (23) coupled to the gate of the controllable switch (3) and connected in between the gate of the controllable switch (3) and the reference potential,
wherein the gate driver circuit (10) is configured to control the second switch (22) and the third switch (23) such that the second switch (22) and the third switch (23) are switched to a conducting state in a time-offset manner.

## Patentansprüche

1. Betriebsvorrichtung für eine Lichtquelle (1), umfassend:
einen steuerbaren Schalter (3), der ein Gate aufweist, und
eine Gate-Treiberschaltung (10), die mit dem Gate des steuerbaren Schalters (3) verbunden ist,
wobei die Gate-Treiberschaltung (10) eine Induktivität (11) umfasst, die eine Resonanzschaltung mit einer Kapazität des Gates des steuerbaren Schalters (3) bildet,
wobei die Gate-Treiberschaltung (10) einen ersten Schalter (21) umfasst, der mit der Induktivität (11) in Reihe mit einer Spannungsschiene verbunden ist, gemessen im Verhältnis zu einem Referenzpotential,
wobei die Gate-Treiberschaltung (10) einen zweiten Schalter (22) umfasst, der über die Induktivität (11) mit dem Gate des steuerbaren Schalters (3) verbunden ist und zwischen die Induktivität (11) und das Referenzpotential geschaltet ist,
**dadurch gekennzeichnet, dass** die Gate-Treiberschaltung (10) einen dritten Schalter (23) umfasst, der mit dem Gate des steuerbaren Schalters (3) verbunden ist und zwischen das Gate des steuerbaren Schalters (3) und das Referenzpotential geschaltet ist,
wobei die Gate-Treiberschaltung (10) dazu gestaltet ist, den zweiten Schalter (22) und den dritten Schalter (23) derart zu steuern, dass der zweite Schalter (22) und der dritte Schalter (23) zeitlich versetzt in den leitenden Zustand geschaltet werden.

2. Betriebsvorrichtung nach Anspruch 1,
wobei die Resonanzschaltung gestaltet ist zum Verstärken
einer Gate-Spannung am Gate des steuerbaren Schalters (3) und/oder
einer Stromamplitude eines Stroms, der zu dem Gate des steuerbaren Schalters (3) fließt.

3. Betriebsvorrichtung nach Anspruch 1 oder Anspruch 2,
wobei die Gate-Treiberschaltung (10) dazu gestaltet ist, ein Schalten des ersten Schalters (21) in Abhängigkeit von einer Resonanzfrequenz der Resonanzschaltung zu steuern.

4. Betriebsvorrichtung nach einem der vorhergehenden Ansprüche,
wobei der erste Schalter (21) und die Induktivität (11) in Reihe zwischen der Spannungsschiene und dem Gate des steuerbaren Schalters (3) verbunden sind.

5. Betriebsvorrichtung nach einem der vorhergehenden Ansprüche,
wobei die Gate-Treiberschaltung (10) dazu gestaltet ist, ein Schalten von sowohl dem ersten Schalter (21) als auch dem zweiten Schalter (22) in Abhängigkeit von einer Resonanzfrequenz der Resonanzschaltung zu steuern.

6. Betriebsvorrichtung nach einem der vorhergehenden Ansprüche,
wobei der erste Schalter (21) und der zweite Schalter (22) in einer integrierten Schaltung (30) enthalten sind.

7. Betriebsvorrichtung nach einem der vorhergehenden Ansprüche,
wobei die Gate-Treiberschaltung (10) dazu gestaltet ist, ein weiches Schalten durchzuführen, wenn sie den steuerbaren Schalter (3) anschaltet und/oder ausschaltet.

8. Betriebsvorrichtung nach einem der vorhergehenden Ansprüche,
wobei der steuerbare Schalter (3) ein steuerbarer Schalter eines Transformators (41, 42, 45-49) mit einer Potentialbarriere (59) ist.

9. Betriebsvorrichtung nach einem der vorhergehenden Ansprüche,
wobei die Betriebsvorrichtung (10) ein LED-Umrichter ist.

10. Lichtquelle, umfassend:
ein lichtemittierendes Mittel (5), das mindestens eine Leuchtdiode (6) umfasst, und
die Betriebsvorrichtung (10) nach einem der vorhergehenden Ansprüche, wobei ein Ausgang der Betriebsvorrichtung (10) mit dem lichtemittierenden Mittel (5) verschaltet ist, um einen Betriebsstrom zu dem lichtemittierenden Mittel (5) zu speisen.

11. Verfahren zum Steuern einer Betriebsvorrichtung für eine Lichtquelle (1), wobei die Betriebsvorrichtung einen steuerbaren Schalter (3) mit einem Gate umfasst, wobei das Verfahren Folgendes umfasst:
Steuern des steuerbaren Schalters (3) durch eine Gate-Treiberschaltung (10), die mit dem Gate des steuerbaren Schalters (3) verbunden ist, wobei die Gate-Treiberschaltung (10) eine Induktivität (11) umfasst, die eine Resonanzschaltung mit einer Kapazität des Gates des steuerbaren Schalters (3) bildet,
wobei die Gate-Treiberschaltung (10) einen ersten Schalter (21) umfasst, der in Reihe mit der Induktivität (11) mit einer Spannungsschiene verbunden ist, gemessen im Verhältnis zu einem Referenzpotential,
wobei die Gate-Treiberschaltung (10) einen zweiten Schalter (22) umfasst, der über die Induktivität (11) mit dem Gate des steuerbaren Schalters (3) verbunden ist und zwischen die Induktivität (11) und das Referenzpotential geschaltet ist,
**dadurch gekennzeichnet, dass** die Gate-Treiberschaltung (10) einen dritten Schalter (23) umfasst, der mit dem Gate des steuerbaren Schalters (3) verbunden ist und zwischen das Gate des steuerbaren Schalters (3) und das Referenzpotential geschaltet ist,
wobei die Gate-Treiberschaltung (10) dazu gestaltet ist, den zweiten Schalter (22) und den dritten Schalter (23) derart zu steuern, dass der zweite Schalter (22) und der dritte Schalter (23) zeitlich versetzt in den leitenden Zustand geschaltet werden.

## Revendications

1. Dispositif de mise en oeuvre pour une source de lumière (1), comprenant :
un commutateur pouvant être commandé (3) qui comporte une grille ; et
un circuit de commande de grille (10) couplé à la grille du commutateur pouvant être commandé (3),
dans lequel le circuit de commande de grille (10) comprend une inductance (11) formant un circuit résonant avec une capacitance de la grille du commutateur pouvant être commandé (3),
dans lequel le circuit de commande de grille (10) comprend un premier commutateur (21) couplé en série avec l'inductance (11) à un rail de tension, mesuré par rapport à un potentiel de référence,
dans lequel le circuit de commande de grille (10) comprend un deuxième commutateur (22) couplé, par l'intermédiaire de l'inductance (11), à la grille du commutateur pouvant être commandé (3) et connecté entre l'inductance (11) et le potentiel de référence,
**caractérisé en ce que** le circuit de commande de grille (10) comprend un troisième commutateur (23) couplé à la grille du commutateur pouvant être commandé (3) et connecté entre la grille du commutateur pouvant être commandé (3) et le potentiel de référence,
dans lequel le circuit de commande de grille (10) est configuré pour commander le deuxième commutateur (22) et le troisième commutateur (23) de sorte que le deuxième commutateur (22) et le troisième commutateur (23) soient commutés vers un état conducteur d'une manière décalée dans le temps.

2. Dispositif de mise en oeuvre selon la revendication 1,
dans lequel le circuit résonant est configuré pour amplifier
une tension de grille au niveau de la grille du commutateur pouvant être commandé (3), et/ou
une amplitude de courant d'un courant circulant vers la grille du commutateur pouvant être commandé (3).

3. Dispositif de mise en oeuvre selon la revendication 1 ou la revendication 2,
dans lequel le circuit de commande de grille (10) est configuré pour commander une commutation du premier commutateur (21) en fonction d'une fréquence de résonance du circuit résonant.

4. Dispositif de mise en oeuvre selon l'une quelconque des revendications précédentes,
dans lequel le premier commutateur (21) et l'inductance (11) sont couplés en série entre le rail de tension et la grille du commutateur pouvant être commandé (3).

5. Dispositif de mise en oeuvre selon l'une quelconque des revendications précédentes,
dans lequel le circuit de commande de grille (10) est configuré pour commander une commutation à la fois du premier commutateur (21) et du deuxième commutateur (22) en fonction d'une fréquence de résonance du circuit résonant.

6. Dispositif de mise en oeuvre selon l'une quelconque des revendications précédentes,
dans lequel le premier commutateur (21) et le deuxième commutateur (22) sont inclus dans un circuit intégré (30).

7. Dispositif de mise en oeuvre selon l'une quelconque des revendications précédentes,
dans lequel le circuit de commande de grille (10) est configuré pour effectuer une commutation logicielle lors de la fermeture et/ou lors de l'ouverture du commutateur pouvant être commandé (3).

8. Dispositif de mise en oeuvre selon l'une quelconque des revendications précédentes,
dans lequel le commutateur pouvant être commandé (3) est un commutateur pouvant être commandé d'un transformateur (41, 42, 45 à 49) ayant une barrière de potentiel (59).

9. Dispositif de mise en oeuvre selon l'une quelconque des revendications précédentes,
dans lequel le dispositif de mise en oeuvre (10) est un convertisseur de DEL.

10. Source de lumière, comprenant :
des moyens d'émission de lumière (5) comprenant au moins une diode électroluminescente (6), et
le dispositif de mise en oeuvre (10) selon l'une quelconque des revendications précédentes, dans laquelle une sortie du dispositif de mise en oeuvre (10) est connectée aux moyens d'émission de lumière (5) pour fournir un courant de fonctionnement aux moyens d'émission de lumière (5).

11. Procédé de commande d'un dispositif de mise en oeuvre pour une source de lumière (1), le dispositif de mise en oeuvre comprenant un commutateur pouvant être commandé (3) comportant une grille, le procédé comprenant :
la commande du commutateur pouvant être commandé (3) par un circuit de commande de grille (10) couplé à la grille du commutateur pouvant être commandé (3), dans lequel le circuit de commande de grille (10) comprend une inductance (11) qui forme un circuit résonant avec une capacitance de la grille du commutateur pouvant être commandé (3),
dans lequel le circuit de commande de grille (10) comprend un premier commutateur (21) couplé en série avec l'inductance (11) à un rail de tension, mesuré par rapport à un potentiel de référence,
dans lequel le circuit de commande de grille (10) comprend un deuxième commutateur (22) couplé, par l'intermédiaire de l'inductance (11), à la grille du commutateur pouvant être commandé (3) et connecté entre l'inductance (11) et le potentiel de référence,
**caractérisé en ce que** le circuit de commande de grille (10) comprend un troisième commutateur (23) couplé à la grille du commutateur pouvant être commandé (3) et connecté entre la grille du commutateur pouvant être commandé (3) et le potentiel de référence,
dans lequel le circuit de commande de grille (10) est configuré pour commander le deuxième commutateur (22) et le troisième commutateur (23) de sorte que le deuxième commutateur (22) et le troisième commutateur (23) soient commutés vers un état conducteur d'une manière décalée dans le temps.
